# EUROPEAN PATENT APPLICATION

(11) **EP 4 779 687 A1**
(43) Date of publication of application: **22.07.2026**
(21) Application number: 25152373.4
(22) Date of filing: 16.01.2025
(51) Int. Cl.: H01L 23/367, H01L 23/467

(54) **A HEAT DISSIPATION ARRANGEMENT FOR ELECTRONIC DEVICES**

(71) Applicant: Magna Electronics Sweden AB, 447 37 Vårgårda (SE)
(72) Inventor: KAMMOUN, Mohamed, 95800 Cergy Saint-Christophe (FR); BOUCOURT, Samuel, 95800 Cergy Saint-Christophe (FR)
(74) Representative: Westpatent AB

(57) **Abstract**

The present disclosure relates to a heat dissipation arrangement (101) for electronic devices (103), comprising a base plate (104) and a plurality of cooling fins (105, 106). The cooling fins (105, 106) are formed on, and protrude from, the base plate (104) in a first region (107) and a second region (108), where most cooling fins (105) in the first region (107) have a corresponding arcuate shape. The heat dissipation arrangement (101) comprises a third region (112) that at least partly separates the first region (107) from the second region (108) and is adapted to receive air (111) injected by means of an electric fan (102). Most of the cooling fins (106) in the second region (108) are inclined or curved with respect to the direction of incoming ambient air (110) from one direction and air (111) injected by means of an electric fan (102) from another direction, such that ambient air (110) and air (111) injected by means of an electric fan (102) both are guided towards the cooling fins (105) of the first region (107).

## Description

### DESCRIPTION OF THE DISCLOSURE

The present disclosure relates to a heat dissipation arrangement for electronic devices, comprising a base plate and a plurality of cooling fins.

Many electronic devices, for example electronic control units (ECUs) are used in vehicle safety systems and systems for autonomous vehicles. These electronic devices produce heat that has to be dissipated to protect electronic components from overheating.

For an ECU with high power dissipation, fan cooling is a good solution. But the use of the fan should be limited in order to avoid its wear and tear during the product lifetime. Therefore, passive cooling in the form of cooling fins has to be included and optimized.

It is desired to find the best cooling fin structure to combine passive cooling at low ambient temperature and fan cooling at high ambient temperature for an electronic device, such as a ECU, with respecting the dimensions and the fixation position available.

The object of the present disclosure is to provide a heat dissipation arrangement that combines passive cooling at low ambient temperature and fan cooling at high ambient temperature in an efficient manner.

This object is obtained by means of a heat dissipation arrangement heat dissipation arrangement for electronic devices, comprising a base plate and a plurality of cooling fins. The cooling fins are formed on, and protrude from, the base plate in a first region and a second region. Most cooling fins in the first region have a corresponding arcuate shape. The heat dissipation arrangement comprises a third region that at least partly separates the first region from the second region and is adapted to receive air injected by means of an electric fan. Most of the cooling fins in the second region are inclined or curved with respect to the direction of incoming ambient air from one direction and air injected by means of an electric fan from another direction. This way, ambient air and air injected by means of an electric fan are both guided towards the cooling fins of the first region.

This means that the cooling fins in the second region guide air injected by means of the electric fan towards the cooling fins of the first region and prevent air injected by means of the electric fan from leaving the heat dissipation arrangement. At the same time, the cooling fins in the second region guide ambient air towards the cooling fins of the first region.

According to some aspects, each cooling fin arcuate shape is mainly curved around a fourth region that lies on one and the same side of, and at a distance from, the cooling fins of the first region. This way, air that has been injected by means of the fan, as well as incoming ambient air, is guided along a curved path that provides an efficient cooling.

According to some aspects, the third region mainly has the shape of a triangle, where a first triangle side is adapted to face an electric fan. According to some further aspects, the first triangle side faces an acute angle, constituting an opening angle. In this manner air injected by means of the electric fan is guided towards the cooling fins of the first region by means of the third region.

According to some aspects, the heat dissipation arrangement further comprises at least one cooling fin that runs in both the first region and the second region, closing the third region. This further minimizes the amount of injected air that might escape the heat dissipation arrangement.

According to some aspects, the base plate and the fins are formed in the same piece of material. This provides a durable and efficient heat dissipation arrangement that is relatively inexpensive to manufacture, not involving separate parts.

According to some aspects, the heat dissipation arrangement is further adapted to be oriented such that when ambient air is guided towards the cooling fins of the first region via the cooling fins in the second region, the air is moving by means of convection. This means that the heat dissipation arrangement can be positioned or oriented such that the cooling fins in the second region are positioned below the cooling fins of the first region. This means that when ambient air rises toward the heat dissipation arrangement, the ambient air first reaches the cooling fins in the second region.

This object is also obtained by means of an electronic assembly that is associated with the above advantages.

### BRIEF DESCRIPTION OF THE DRAWINGS

The present disclosure will now be described more in detail with reference to the appended drawings, where:
Figure 1 shows a side view of an electronic assembly; and
Figure 2 shows a front view of a heat dissipation arrangement.

### DETAILED DESCRIPTION

Aspects of the present disclosure will now be described more fully hereinafter with reference to the accompanying drawings. The different devices, systems, computer programs and methods disclosed herein can, however, be realized in many different forms and should not be construed as being limited to the aspects set forth herein. Like numbers in the drawings refer to like elements throughout.

The terminology used herein is for describing aspects of the disclosure only and is not intended to limit the present disclosure. As used herein, the singular forms "a", "an" and "the" are intended to include the plural forms as well, unless the context clearly indicates otherwise.

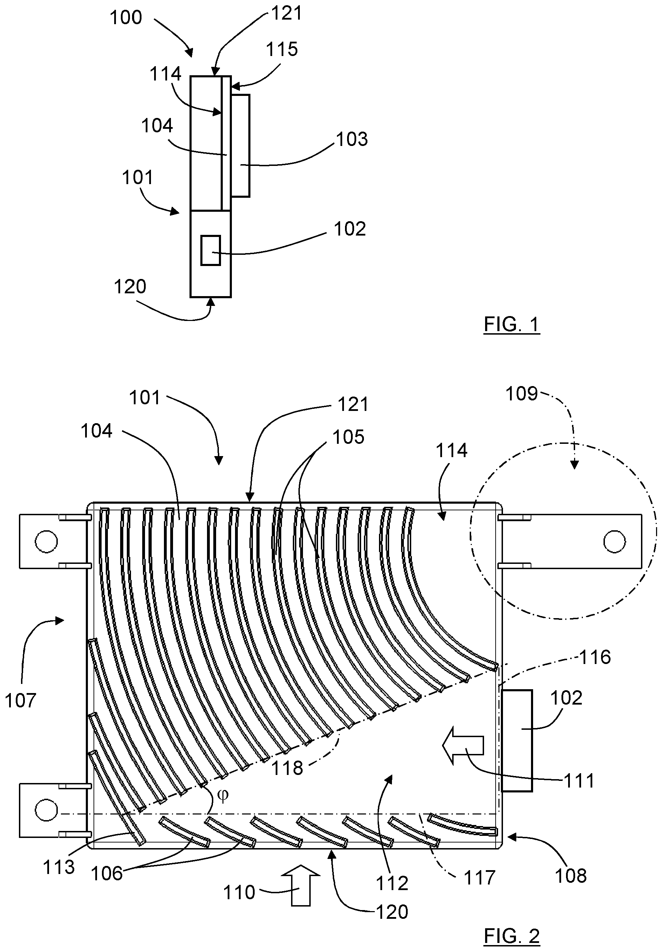

Figure 1 shows an electronic assembly 100 comprising a heat dissipation arrangement 101 for electronic devices 103, and an electronic device 103 that is attached to a base plate 104.

According to some aspects, the base plate 104 has a first main side 114 and a second main side 115, where the electronic device 103 is attached to, and thermally connected to, the second main side 115.

In particular, with reference also to Figure 2, the present disclosure relates to the heat dissipation arrangement 101 that comprises a base plate 104 and a plurality of cooling fins 105, 106 that are formed on, and protrude from, the base plate 104 in a first region 107 and a second region 108. Most cooling fins 105 (only a few indicated in Figure 2 for reasons of clarity) in the first region 107 have a corresponding arcuate shape.

The heat dissipation arrangement 101 comprises a third region 112 that at least partly separates the first region 107 from the second region 108 and is adapted to receive air 111 injected by means of an electric fan 102. Most of the cooling fins 106 in the second region 108 are inclined or curved with respect to the direction of incoming ambient air 110 from one direction and air 111 injected by means of an electric fan 102 from another direction, such that ambient air 110 and air 111 injected by means of an electric fan 102 both are guided towards the cooling fins 105 of the first region 107.

According to some aspects, when most of the cooling fins are constituted in a certain manner, that means that there may be one or more cooling fins constituted in a different manner, but that cooling fin or these colling fins present a minority within the respective region 107, 108.

The cooling fins 106 in the second region 108 thus guide air 111 injected by means of the electric fan 102 towards the cooling fins 105 of the first region 107 and thus prevent air 111 injected by means of the electric fan 102 from leaving the heat dissipation arrangement 101. At the same time, the cooling fins 106 in the second region 108 guide ambient air 110 towards the cooling fins 105 of the first region 107.

According to some aspects, each cooling fin arcuate shape in the first region 107 is mainly curved around a fourth region 109 that lies on one and the same side of, and at a distance from, the cooling fins 105 of the first region 107. According to some aspects, the centers of all curved shapes lie in the region 109. However, the arcuate shapes do not need to be circular or elliptic, but may have any arcuate shape and may therefore not have a clearly defined center. The region 109 is only shown schematically in Figure 2, it can have different shapes and positions. This way, air 111 that has been injected by means of the fan 102, as well as incoming ambient air 110, is guided along a curved path that provides an efficient cooling.

According to some aspects, the third region 112 mainly has the shape of a triangle 116, 117, 118, where a first triangle side 116 is adapted to face an electric fan 102. According to further some aspects, the first triangle side 116 faces an acute angle φ, constituting an opening angle φ.

In this manner air 111 injected by means of the electric fan 102 is guided towards the cooling fins 105 of the first region 107 by means of the third region 112.

According to some aspects, the heat dissipation arrangement 101 further comprises at least one cooling fin 113 that runs in both the first region 107 and the second region 108, closing the third region 112. This further minimizes the amount of injected air 111 that might escape the heat dissipation arrangement 101.

According to some aspects, the base plate 104 and the fins 105, 106, 113 are formed in the same piece of material. This provides a durable and efficient heat dissipation arrangement 101 that is relatively inexpensive to manufacture, not involving separate parts.

According to some aspects, the heat dissipation arrangement 101 is adapted to be oriented such that when ambient air 110 is guided towards the cooling fins 105 of the first region 107 via the cooling fins 106 in the second region 108, the air 110 is moving by means of convection. For example, this means that the heat dissipation arrangement 101 is adapted to be positioned or oriented such that the cooling fins 106 in the second region 108 are positioned below the cooling fins 105 of the first region 107 such that when ambient air 110 rises toward the heat dissipation arrangement 101, the ambient air 110 first reaches the cooling fins 106 in the second region 108.

According to some aspects, the heat dissipation arrangement 101 has a bottom side 120 that is adapted to face downwards and a top side 121 that is adapted to face upwards, where ambient air 110 rises towards the bottom side 120 of the heat dissipation arrangement 101. The ambient air 110 then enters the heat dissipation arrangement 101 via the cooling fins 106 in the second region 108. The cooling fins 106 in the second region 108 are inclined or curved with respect to the direction of incoming ambient air 110 such that ambient air 110 that has entered the heat dissipation arrangement 101 does not escape and instead continues towards the cooling fins 105 of the first region 107.

According to some further aspects, when having absorbed heat from the cooling fins 106, 105, the air 110, 111 that has entered the heat dissipation arrangement 101, ambient air 110 as well as air 111 injected by means of the fan 102, leaves the heat dissipation arrangement 101 via the top side 121.

With reference to Figure 1 and Figure 2, the present disclosure also relates to the electronic assembly 100 comprising the heat dissipation arrangement as described herein, an electric fan 102, and an electronic device 103 that is attached to the base plate 104. The electronic device can for example be an ECU with high power dissipation, requiring cooling in order to avoid overheating.

According to some aspects, the base plate has a first main side 114 and a second main side 115, where the cooling fins 105, 106, 113 protrude from the first main side 114 and where the electronic device 103 is attached to, and thermally connected to, the second main side 115. This ensures a reliable connection between the electronic device 103 and the heat dissipation arrangement 101. For example, a thermally conducting paste may be applied between the electronic device 103 and the second main side 115.

The present disclosure is not limited to the above, but may vary freely within the scope of the appended claims. For example, the heat dissipation arrangement 101 may be made in any suitable conducting material such as a metal, for example aluminum.

## Claims

1. A heat dissipation arrangement (101) for electronic devices (103), comprising a base plate (104) and a plurality of cooling fins (105, 106), where the cooling fins (105, 106) are formed on, and protrude from, the base plate (104) in a first region (107) and a second region (108), where most cooling fins (105) in the first region (107) have a corresponding arcuate shape, where the heat dissipation arrangement (101) comprises a third region (112) that at least partly separates the first region (107) from the second region (108) and is adapted to receive air (111) injected by means of an electric fan (102), where most of the cooling fins (106) in the second region (108) are inclined or curved with respect to the direction of incoming ambient air (110) from one direction and air (111) injected by means of an electric fan (102) from another direction, such that ambient air (110) and air (111) injected by means of an electric fan (102) both are guided towards the cooling fins (105) of the first region (107).

2. The heat dissipation arrangement (101) according to claim 1, wherein each cooling fin arcuate shape mainly is curved around a fourth region (109) that lies on one and the same side of, and at a distance from, the cooling fins (105) of the first region (107).

3. The heat dissipation arrangement (101) according to any one of the claims 1 or 2, wherein the third region (112) mainly has the shape of a triangle (116, 117, 118), where a first triangle side (116) is adapted to face an electric fan (102).

4. The heat dissipation arrangement (101) according to claim 3, wherein the first triangle side (116) faces an acute angle (φ), constituting an opening angle (φ).

5. The heat dissipation arrangement (101) according to any one of the previous claims, further comprising at least one cooling fin (113) that runs in both the first region (107) and the second region (108), closing the third region (112).

6. The heat dissipation arrangement (101) according to any one of the previous claims, wherein the base plate (104) and the fins (105, 106, 113) are formed in the same piece of material.

7. The heat dissipation arrangement (101) according to any one of the previous claims, further being adapted to be oriented such that when ambient air (110) is guided towards the cooling fins (105) of the first region via the cooling fins (106) in the second region (108), the air (110) is moving by means of convection.

8. An electronic assembly (100) comprising the heat dissipation arrangement according to any one of the previous claims, an electric fan (102), and an electronic device (103) that is attached to the base plate (104).

9. The electronic assembly (100) according to claim 8, wherein the base plate has a first main side (114) and a second main side (115), where the cooling fins (105, 106, 113) protrude from the first main side (114) and where the electronic device (103) is attached to, and thermally connected to, the second main side (115).
